# EUROPEAN PATENT APPLICATION

(11) **EP 3 579 283 A1**
(43) Date of publication of application: **11.12.2019**
(21) Application number: 18187672.3
(22) Date of filing: 07.08.2018
(51) Int. Cl.: H01L 31/0224, H01L 31/072, H01L 31/0445

(54) **SOLAR CELL AND MANUFACTURING METHOD THEREFOR**

(30) Priority: 08.06.2018 CN 201820893330 U
(71) Applicant: Hanergy New Material Technology Co., Ltd., Yanqi Industrial Development Zone Huairou District Beijing (CN)
(72) Inventor: Pengju, Zhang, Beijing (CN); Shengchun, Li, Beijing (CN); Xiaotian, Tan, Beijing (CN); Zhijian, Yu, Beijing (CN); Yu, Zhang, Beijing (CN); Zhiqian, Su, Beijing (CN)
(74) Representative: Soria Parra, Manuel

(57) **Abstract**

The present invention relates to a solar cell and a manufacturing method therefor. The solar cell includes: a base substrate; an electrode layer set on a surface of the base substrate, the electrode layer set including a first electrode and a second electrode, and the first electrode and the second electrode being electrically insulated from each other; a photoelectric layer disposed on a side of the electrode layer set facing away from the base substrate and electrically connected to the first electrode, the photoelectric layer being provided with a first via, and the position of the first via corresponding to the position of the second electrode; and a window layer disposed on a side of the photoelectric layer facing away from the base substrate and electrically connected to the second electrode through the first via.

## Description

### TECHNICAL FIELD

The present invention relates to the technical field of solar cells, and in particular, to a solar cell and a manufacturing method therefor.

### BACKGROUND

In recent years, the increasingly prominent traditional energy issues have promoted the rapid development of new energy sources. Especially the clean energy represented by solar energy has received high-degree and extensive attention. Since the core material in the solar cell module is very sensitive to moisture, and exposure to the atmosphere tends to cause attenuation of power generation efficiency, the use of an effective packaging structure is important for ensuring the power generation efficiency and the service life of the solar cell module.

At present, the common packaging structure includes an externally-bonded packaging structure and an alternately stacked packaging structure of an organic thin film and an inorganic thin film. However, the packaging effect and the difficulty level of the packaging process are inevitably affected by the surface flatness of the solar cell. Therefore, ensuring that the surface of the solar cell is flattened is important for the packaging effect.

### SUMMARY

To overcome the problems in the related art, embodiments of the present invention provide a solar cell. The technical solution is as follows.

According to a first aspect of the embodiments of the present invention, there is provided a solar cell, including:
a base substrate;
an electrode layer set disposed on a surface of the base substrate, the electrode layer set including a first electrode and a second electrode, and the first electrode and the second electrode being electrically insulated from each other;
a photoelectric layer disposed on a side of the electrode layer set facing away from the base substrate and electrically connected to the first electrode, the photoelectric layer being provided with a first via, and the position of the first via corresponding to the position of the second electrode; and
a window layer disposed on a side of the photoelectric layer facing away from the base substrate and electrically connected to the second electrode through the first via.

In an embodiment, an orthographic projection of the first electrode on the base substrate and an orthographic projection of the second electrode on the base substrate do not overlap with each other.

In an embodiment, the first electrode and the second electrode are in the same layer, and the first electrode and the second electrode are separated by a predetermined interval.

In an embodiment, the first electrode is disposed on a side of the second electrode facing away from the base substrate, and the electrode layer set further includes an insulating layer disposed between the first electrode and the second electrode.

A second via is disposed in the insulating layer, and a third via is disposed in the first electrode, and positions of the first via, the second via, and the third via are corresponding to one another.

In an embodiment, the first electrode and the second electrode are made of the same material.

In an embodiment, the first electrode and the second electrode are both metal electrodes.

In an embodiment, the window layer is electrically connected to the second electrode through a transparent conductive thin film constituting the window layer or through a solder.

In an embodiment, the solar cell further includes an encapsulation layer on a side of the window layer facing away from the base substrate.

In an embodiment, the encapsulation layer includes:
a planar layer disposed on a side of the window layer facing away from the base substrate; and
a protective layer disposed on a side of the planar layer facing away from the base substrate.

In an embodiment, the planar layer includes an organic planar layer and the protective layer includes an inorganic protective layer.

According to a second aspect of the embodiments of the present invention, there is provided a manufacturing method for a solar cell, including:
forming an electrode layer set on a base substrate, wherein the electrode layer set comprises a first electrode and a second electrode, and the first electrode and the second electrode are electrically insulated from each other;
forming a photoelectric layer on a side of the electrode layer set facing away from the base substrate and electrically connected to the first electrode, wherein the photoelectric layer is provided with a first via, and the position of the first via corresponds to the position of the second electrode; and
forming a window layer on a side of the photoelectric layer facing away from the base substrate and electrically connected to the second electrode through the first via.

In an embodiment, forming an electrode layer set on a base substrate comprises:
forming on the base substrate the first electrode and the second electrode that are in the same layer and are separated by a predetermined interval.

In an embodiment, forming an electrode layer set on a base substrate comprises:
forming the second electrode on the base substrate;
forming an insulating layer with a second via on a side of the second electrode facing away from the base substrate; and
forming the first electrode with a third via on a side of the insulating layer facing away from the base substrate, wherein positions of the first via, the second via, and the third via are corresponding to one another.

The technical solution provided by the embodiment of the present invention may include the following beneficial effects: by disposing both the first electrode and the second electrode below the photoelectric layer, on the one hand, it can effectively avoid the shielding of the electrode from the photoelectric layer, so as to increase the aperture ratio of the solar cell, thereby improving its power generation efficiency. On the other hand, a recess structure corresponding to the second electrode may be formed on the surface of the window layer. Compared with a protrusion structure of the second electrode protruding beyond the surface of the window layer, the recess structure is more easily filled and leveled up, thereby facilitating planarization of the surface of the solar cell, so as to reduce the process difficulty of the thin film packaging and improve the effect of the thin film packaging.

It should be understood that both the foregoing general description and the following detailed description are exemplary and explanatory only and are not restrictive of the invention.

### BRIEF DESCRIPTION OF THE DRAWINGS

The accompanying drawings herein, which are incorporated in and constitute a part of this specification, illustrate embodiments consistent with the present invention and, together with the description, serve to explain the principles of the present invention.
Fig. 1 is a schematic structural diagram of a solar cell in the prior art;
Fig. 2 is a schematic structural diagram of a solar cell according to an exemplary embodiment;
Fig. 3 is a first schematic diagram of a packaging structure of a solar cell according to an exemplary embodiment;
Fig. 4 is a first plan view of a solar cell according to an exemplary embodiment;
Fig. 5 is a first schematic diagram of a packaging structure of a solar cell according to an exemplary embodiment;
Fig. 6 is a second plan view of a solar cell according to an exemplary embodiment; and
Fig. 7 is a flowchart showing a manufacturing method for a solar cell according to an exemplary embodiment.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the present invention. Instead, they are merely examples of devices and methods consistent with aspects related to the present invention as recited in the appended claims.

Considering that the core material of the solar cell module is very sensitive to moisture, it is necessary to adopt a specific packaging structure to prevent the intrusion of moisture, thereby ensuring the power generation efficiency and the service life of the solar cell. At present, the common packaging structure includes an alternately stacked packaging structure of an organic thin film and an inorganic thin film. However, the packaging effect and the difficulty level of the packaging process are inevitably affected by the surface flatness of the solar cell.

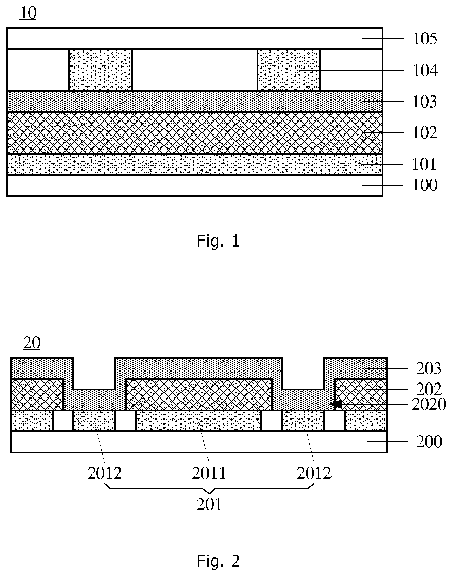

Fig. 1 exemplarily shows a schematic structural diagram of a solar cell in the related art. As can be seen from Fig. 1, the solar cell 10 may include a base substrate 100; a first electrode 101, a photoelectric layer 102, a window layer 103, and a second electrode 104 which are sequentially disposed on the base substrate 100; and an encapsulation layer 105 over the second electrode 104. The first electrode 101 is a planar electrode and is laid on the surface of the base substrate 100. The second electrode 104 is a strip electrode and is distributed on the surface of the window layer 103.

Based on the structure, since the second electrode 104 is formed on the surface of the window layer 103 by a process such as lamination or screen printing, the thickness thereof is at least several micrometers or even tens of micrometers, and the thickness of the thin film packaging layer 105 is relatively small usually at only 2∼3 micrometers or even thinner, the thickness of the second electrode 104 is too large compared to the encapsulation layer 105, which will directly affect the process difficulty and packaging effect of the thin film packaging.

The technical solution provided by the embodiment of the present invention relates to a solar cell 20. As shown in Fig. 2, the solar cell 20 includes:

a base substrate 200, such as a flexible substrate or a glass substrate;

an electrode layer set 201, disposed on the surface of the base substrate 200, wherein the electrode layer set 201 includes a first electrode 2011 and a second electrode 2012, and the first electrode 2011 and the second electrode 2012 are electrically insulated from each other;

a photoelectric layer 202, disposed on a side of the electrode layer set 201 facing away from the base substrate 200, and electrically connected to the first electrode 2011, wherein the photoelectric layer 202 is provided with a first via 2020, and the position of the first via 2020 corresponds to the position of the second electrode 2012;

a window layer 203, disposed on a side of the photoelectric layer 202 facing away from the base substrate 200, and electrically connected to the second electrode 2012 through the first via 2020.

The photoelectric layer 202 may include a photoelectric conversion semiconductor thin film such as a crystalline silicon semiconductor thin film or a CIGS (CuInGaSe) semiconductor thin film. The window layer 203 may be a transparent conductive thin film such as ITO (Indium Tin Oxide) thin film or AZO (Aluminum doped Zinc Oxid) thin film.

In the technical solution provided by the embodiment of the present invention, by disposing both the first electrode 2011 and the second electrode 2012 below the photoelectric layer 202, it can effectively avoid the shielding of the electrode from the photoelectric layer 202, so as to increase the aperture ratio of the solar cell 20, thereby improving its power generation efficiency. On the other hand, a recess structure corresponding to the second electrode 2012 may be formed on the surface of the window layer 203. Compared with a protrusion structure of the second electrode 2012 protruding beyond the surface of the window layer 203, the recess structure is more easily filled and leveled up, thereby facilitating planarization of the surface of the solar cell 20, so as to reduce the process difficulty of the thin film packaging and improve the effect of the thin film packaging.

In the present exemplary embodiment, the orthographic projection of the first electrode 2011 on the base substrate 200 and the orthographic projection of the second electrode 2012 on the base substrate 200 are mutually staggered, i.e., not overlapping with each other. The first electrode 2011 serves as a positive electrode of the solar cell 20, and for example, may have a planar electrode structure having an opening. The second electrode 2012 serves as a negative electrode of the solar cell 20, and for example, may have a strip electrode structure corresponding to the position of the opening.

Considering that the first electrode 2011 and the second electrode 2012 are both disposed on the side of the photoelectric layer 202 facing away from the window layer 203, and the window layer 203 needs to be electrically connected to the second electrode 2012 through the first via 2020 in the photoelectric layer 202, the window layer 203 may be electrically connected to the second electrode 2012 by forming a transparent conductive thin film constituting the window layer 203 or even by soldering, in order to ensure the reliability of the electrical connection between the window layer 203 and the second electrode 2012. Forming the transparent conductive thin film means that the transparent conductive film itself can be directly formed on the surface of the second electrode 2012 through the first via 2020 in the process of forming the window layer 203, to achieve an electrical connection therebetween. However, in a case where the distance between the window layer 203 and the second electrode 2012 (i.e., the depth of the via through which the window layer 203 is to pass) is large, the connection through the via may affect the reliability of the electrical connection therebetween. Therefore, soldering is further employed to ensure the reliability of the electrical connection therebetween.

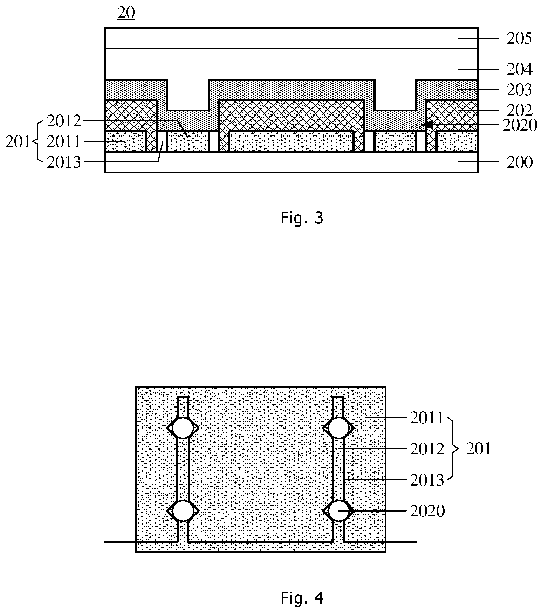

In one embodiment, as shown in Fig. 3, the first electrode 2011 and the second electrode 2012 may be located in the same layer. For example, the first electrode 2011 and the second electrode 2012 may be formed on the same conductive layer and by the same photolithography process. The first electrode 2011 and the second electrode 2012 are separated by a predetermined interval to ensure an electrical insulation between the two electrodes. For example, as shown in Fig. 4, the predetermined interval between the first electrode 2011 and the second electrode 2012 may be formed by performing a scribe process (for example, providing a groove 2013) at a preset position of the conductive layer. Alternatively, it is also possible to form the first electrode 2011, and then form the second electrode 2012 at a predetermined interval from the first electrode 2011. This is not specifically limited in this embodiment.

In this case, referring to Fig. 3, the solar cell 20 may include a base substrate 200; an electrode layer set 201 disposed on the base substrate 200 and composed of a first electrode 2011 and a second electrode 2012 disposed in the same layer and spaced apart by a predetermined interval; a photoelectric layer 202 disposed on the electrode layer set 201, electrically connected to the first electrode 2011 and having a first via 2020 corresponding to the second electrode 2012; a window layer 203 disposed on the photoelectric layer 202 and electrically connected to the second electrode 2012 through the first via 2020; and a packaging structure such as a planar layer 204 and a protective layer 205 disposed on the window layer 203.

Referring to Fig. 4, the predetermined interval between the first electrode 2011 and the second electrode 2012 can be achieved by providing the groove 2013, and the groove can be filled with insulating material or not filled with any material, as long as it can guarantee the electrical insulation between the first electrode 2011 and the second electrode 2012 and an electrical insulation between the first electrode 2011 and the window layer 203. It should be noted that since the photoelectric layer 202 covers the surface of the first electrode 2011 during the process of forming the photoelectric layer 202, it is only necessary to control the etching precision of the photoelectric layer 202 to ensure that the window layer 203 and the first electrode 2011 are not in contact with each other.

Based on this, in the present embodiment, by disposing the first electrode 2011 and the second electrode 2012 in the same layer and below the photoelectric layer 202, on the one hand, the light receiving area of the solar cell 20 can be increased, thereby improving the power generation efficiency of the solar cell 20. On the other hand, it can reduce the number of electrode deposition processes, which saves raw materials and simplifies the process. For example, if the first electrode 2011 and the second electrode 2012 are formed based on the same conductive layer, such as a metal molybdenum Mo conductive layer, and are formed through the same photolithography process, i.e., the first electrode 2011 and the second electrode 2012 are formed by performing a grooving process on the conductive layer, the thickness of the electrode layer set 201 can be relatively thin, the step difference can be relatively small, and the depth of the groove formed by the film layer located thereon can also be small. Therefore, the surface can be more easily filled and leveled up such that the surface flatness of the solar cell 20 can be improved to facilitate film encapsulation.

In addition, the first electrode 2011 and the second electrode 2012 may be made of the same material, and for example, they both are formed based on the same conductive layer. The first electrode 2011 and the second electrode 2012 each may be a metal electrode such as a metal molybdenum Mo electrode. Since the molybdenum Mo electrode is usually formed by a sputtering process, not only it can exhibit excellent film quality, but also can have low electric resistance, so that the thickness of the electrode can be significantly reduced.

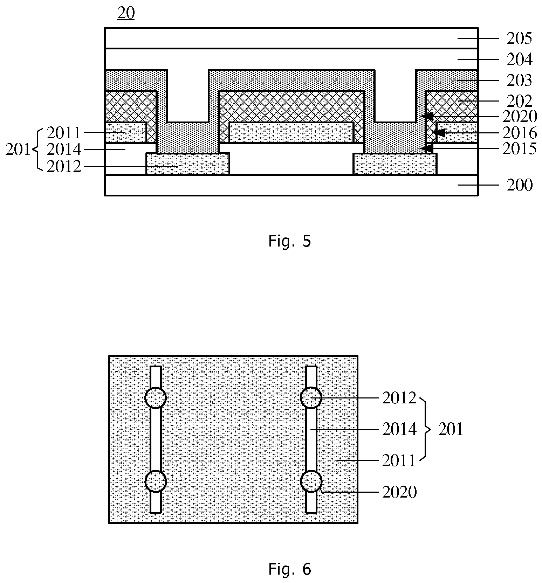

In another embodiment, as shown in Fig. 5, the first electrode 2011 and the second electrode 2012 may be disposed in different layers. The first electrode 2011 is disposed in the upper side, i.e., away from the base substrate 200, the second electrode 2012 is disposed on the lower side, i.e., proximate to the base substrate 200, and an insulating layer 2014 is further provided between the first electrode 2011 and the second electrode 2012. As shown in Fig. 6, a second via 2015 is disposed in the insulating layer 2014, and a third via 2016 is disposed in the first electrode 2011. The position of the second via 2015 and the position of the third via 2016 directly correspond to the position of the first via 2020, to facilitate ensuring an electrical connection between the window layer 203 and the second electrode 2012.

In this case, referring to Fig. 5, the solar cell 20 may include a base substrate 200; a second electrode 2012 disposed on the base substrate 200; an insulating layer 2014 disposed on the second electrode 2012 and having the second via 2015; a first electrode 2011 disposed on the insulating layer 2014 and having a third via 2016 corresponding to the second via 2015; a photoelectric layer 202 disposed on the first electrode 2011 and having a first via 2020 corresponding to the second via 2015; a window layer 203 disposed on the photoelectric layer 202 and electrically connected to the second electrode 2012 through the first via 2020, the second via 2015 and the third via 2016; and a packaging structure disposed on the window layer 203 such as a planar layer 204 and a protective layer 205.

Here, referring to Fig. 6, the first electrode 2011, the second electrode 2012, and the insulating layer 2014 therebetween together form the electrode layer set 201. The first electrode 2011 may be correspondingly disposed at a first preset position, the second electrode 2012 may be correspondingly disposed at a second preset position, and the projections of the two preset positions on the base substrate 200 are mutually staggered, for example, not overlapping with each other. It should be noted that, in order to ensure an electrical insulation between the window layer 203 and the first electrode 2011, in the embodiment, it may control the etching precision of the photoelectric layer 202 during the process of forming the photoelectric layer 202, so that the photoelectric layer 202 can cover the first electrode 2011. In addition, in the embodiment, the aperture of the third via 2016 can be controlled to be larger than the aperture of the first via 2020. In this case, the photoelectric layer 202 can be coated on the surface of the first electrode 2011, without being required to extend to the insulating layer 2014.

Based on this, in the embodiment, the first electrode 2011 and the second electrode 2012 are disposed in different layers and disposed below the photoelectric layer 202, so that the light-receiving area of the solar cell 20 can be increased, thereby improving the power generation efficiency of the solar cell 20. For example, in the present embodiment, if the first electrode 2011 and the second electrode 2012 are formed based on different conductive layers, the second electrode 2012 such as a metal silver Ag electrode may be first formed on the base substrate 200 through one photolithography process, then an insulating layer 2014 having a second via 2015 may be deposited on the second electrode 2012, next a first electrode 2011 having a third via 2016, such as a metal molybdenum Mo electrode, is formed on the insulating layer 2014 through one photolithography process, thereby forming the desired electrode layer set 201. It should be noted that the second via 2015 in the insulating layer 2014 and the third via 2016 in the first electrode 2011 can be realized by a laser etching process, in addition to the masking method and the photolithography process. The embodiment does not limit this. In this way, the film layer disposed above the electrode layer set 201 can form a groove structure at a position corresponding to the second electrode 2012, and the groove structure is more easily filled with the surface than the protrusion structure. Therefore, the surface flatness of the solar cell 20 can be improved to facilitate film packaging.

Based on this embodiment, the first electrode 2011 and the second electrode 2012 may be made of the same material, i.e., both the first electrode 2011 and the second electrode 2012 are formed based on the same conductive film. The first electrode 2011 and the second electrode 2012 each may be a metal electrode such as a metal molybdenum Mo electrode. Since the molybdenum Mo electrode is usually formed by a sputtering process, not only it can exhibit excellent film quality, but also can have low electric resistance, so that the thickness of the electrode can be significantly reduced. Alternatively, the first electrode 2011 and the second electrode 2012 may also be made of different materials, i.e., the first electrode 2011 and the second electrode 2012 are formed based on different conductive films. For example, the first electrode 2011 is a metal molybdenum Mo electrode, and the second electrode 2012 is a metal aluminum Al electrode. This embodiment does not limit this.

In the present exemplary embodiment, referring to Fig. 3 and Fig. 5, the solar cell 20 may further include an encapsulation layer on a side of the window layer 203 facing away from the base substrate 200. The encapsulation layer may be used to protect the solar cell from moisture. erosion. The encapsulation layer can adopt a lamination structure of an organic film and an inorganic film, so as to improve the water vapor barrier capability of the encapsulation layer.

For example, the encapsulation layer may include a planar layer 204 on the side of the window layer 203 facing away from the base substrate 200 and a protective layer 205 on the side of the planar layer 204 facing away from the base substrate 200. The planar layer 204 can be used to fill and level up the surface of the window layer 203 to facilitate the preparation of the subsequent film layer, and the planar layer 204 can be made of, for example, an organic resin material to form a thick and flexible organic planar layer. The protective layer 205 can be used to protect the surface of the solar cell, to reduce the damaged cracking, and for example, the protective layer 205 can be made of an inorganic film having a high hardness and a high water blocking ability such as a silicon nitride film or a diamond-like film.

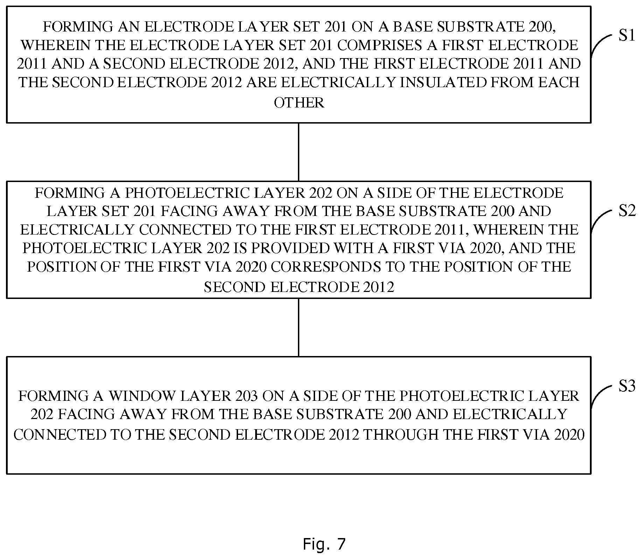

The embodiments of the present invention relates to a manufacturing method for a solar cell. As shown in Fig. 7, the manufacturing method for a solar cell includes the following steps.

Step S1: forming an electrode layer set 201 on a base substrate 200, wherein the electrode layer set 201 comprises a first electrode 2011 and a second electrode 2012, and the first electrode 2011 and the second electrode 2012 are electrically insulated from each other.

Step S2: forming a photoelectric layer 202 on a side of the electrode layer set 201 facing away from the base substrate 200 and electrically connected to the first electrode 2011, wherein the photoelectric layer 202 is provided with a first via 2020, and the position of the first via 2020 corresponds to the position of the second electrode 2012.

Step S3: forming a window layer 203 on a side of the photoelectric layer 202 facing away from the base substrate 200 and electrically connected to the second electrode 2012 through the first via 2020.

For example, the first electrode 2011 and the second electrode 2012 that are in the same layer and are separated by a predetermined interval are formed on the base substrate 200.

For example, the second electrode 2012 is formed on the base substrate 200; an insulating layer 2014 with a second via 2015 is formed on a side of the second electrode 2012 facing away from the base substrate 200; and the first electrode 2011 with a third via 2016 is formed on a side of the insulating layer 2014 facing away from the base substrate 200. Positions of the first via 2020, the second via 2015, and the third via 2016 are corresponding to one another.

Other embodiments of the invention will be apparent to those skilled in the art from consideration of the specification and practice of the invention disclosed here. This application is intended to cover any variations, uses, or adaptations of the invention following the general principles thereof and including such departures from the present invention as come within known or customary practice in the art. It is intended that the specification and examples be considered as exemplary only, with a true scope of the invention being indicated by the following claims.

It will be appreciated that the present invention is not limited to the exact construction that has been described above and illustrated in the accompanying drawings, and that various modifications and changes may be made without departing from the scope thereof. It is intended that the scope of the invention only be limited by the appended claims.

## Claims

1. A solar cell, comprising:
a base substrate (200);
an electrode layer set (201) disposed on a surface of the base substrate (200), wherein the electrode layer set (201) comprises a first electrode (2011) and a second electrode (2012), and the first electrode (2011) and the second electrode (2012) are electrically insulated from each other;
a photoelectric layer (202) disposed on a side of the electrode layer set (201) facing away from the base substrate (200) and electrically connected to the first electrode (2011), wherein the photoelectric layer (202) is provided with a first via (2020), and the position of the first via (2020) corresponds to the position of the second electrode (2012); and
a window layer (203) disposed on a side of the photoelectric layer (202) facing away from the base substrate (200) and electrically connected to the second electrode (2012) through the first via (2020).

2. The solar cell according to claim 1, wherein an orthographic projection of the first electrode (2011) on the base substrate (200) and an orthographic projection of the second electrode (2012) on the base substrate (200) do not overlap with each other.

3. The solar cell according to claim 1, wherein the first electrode (2011) and the second electrode (2012) are in the same layer, and the first electrode (2011) and the second electrode (2012) are separated by a predetermined interval.

4. The solar cell according to claim 1, wherein the first electrode (2011) is disposed on a side of the second electrode (2012) facing away from the base substrate (200), and the electrode layer set (201) further comprises an insulating layer (2014) disposed between the first electrode (2011) and the second electrode (2012),
wherein a second via (2015) is disposed in the insulating layer (2014), and a third via (2016) is disposed in the first electrode (2011), and positions of the first via (2020), the second via (2015), and the third via (2016) are corresponding to one another.

5. The solar cell according to claim 1, wherein the window layer (203) is electrically connected to the second electrode (2012) through a transparent conductive thin film constituting the window layer (203) or through a solder.

6. The solar cell according to claim 1, wherein the solar cell further comprises an encapsulation layer on a side of the window layer (203) facing away from the base substrate (200).

7. The solar cell according to claim 6, wherein the encapsulation layer comprises:
a planar layer (204) disposed on a side of the window layer (203) facing away from the base substrate (200), wherein the planar layer (204) comprises an organic planar layer; and
a protective layer (205) disposed on a side of the planar layer (204) facing away from the base substrate (200), wherein the protective layer (205) comprises an inorganic protective layer.

8. A manufacturing method for a solar cell, comprising:
forming (S1) an electrode layer set (201) on a base substrate (200),
wherein the electrode layer set (201) comprises a first electrode (2011) and a second electrode (2012), and the first electrode (2011) and the second electrode (2012) are electrically insulated from each other;
forming (S2) a photoelectric layer (202) on a side of the electrode layer set (201) facing away from the base substrate (200) and electrically connected to the first electrode (2011), wherein the photoelectric layer (202) is provided with a first via (2020), and the position of the first via (2020) corresponds to the position of the second electrode (2012); and forming (S3) a window layer (203) on a side of the photoelectric layer (202) facing away from the base substrate (200) and electrically connected to the second electrode (2012) through the first via (2020).

9. The manufacturing method according to claim 8, forming (S1) an electrode layer set (201) on a base substrate (200) comprises:
forming on the base substrate (200) the first electrode (2011) and the second electrode (2012) that are in the same layer and are separated by a predetermined interval.

10. The manufacturing method according to claim 9, forming (S1) an electrode layer set (201) on a base substrate (200) comprises:
forming the second electrode (2012) on the base substrate (200);
forming an insulating layer (2014) with a second via (2015) on a side of the second electrode (2012) facing away from the base substrate (200);
and
forming the first electrode (2011) with a third via (2016) on a side of the insulating layer (2014) facing away from the base substrate (200), wherein
positions of the first via (2020), the second via (2015), and the third via (2016) are corresponding to one another.
